# EUROPEAN PATENT APPLICATION

(11) **EP 1 263 041 A2**
(43) Date of publication of application: **04.12.2002**
(21) Application number: 01120752.9
(22) Date of filing: 06.09.2001
(51) Int. Cl.: H01L 23/48, H01L 25/16

(54) **Semiconductor Module**

(30) Priority: 30.05.2001 JP 2001162627
(71) Applicant: Hitachi, Ltd., Chiyoda-ku, Tokyo 101-8010 (JP)
(72) Inventor: Shirakawa, Shinji, Hitachi, Ltd., Int. Prop. Gp., Chiyoda-ku, Tokyo 100-8220 (JP); Mishima, Akira, Hitachi, Ltd., Int. Prop. Gp., Chiyoda-ku, Tokyo 100-8220 (JP); Mashino, Keiichi, Hitachi, Ltd., Int. Prop. Gp., Chiyoda-ku, Tokyo 100-8220 (JP); Innami, Toshiyuki, Hitachi, Ltd., Int. Prop. Gp., Chiyoda-ku, Tokyo 100-8220 (JP); Anan, Hiromichi, Hitachi, Ltd., Int. Prop. Gp., Chiyoda-ku, Tokyo 100-8220 (JP); Ochiai, Yoshitaka, Hitachi, Ltd., Int. Prop. Gp., Chiyoda-ku, Tokyo 100-8220 (JP)
(74) Representative: Beetz & Partner Patentanwälte

(57) **Abstract**

The invention relates to a semiconductor device (30) including a positive polarity wiring plate (3), negative wiring plate (2), more than one output wiring plate (4-6, 4'-6'), semiconductor switch elements (12a-12c) and conductive buffer or "cushion" members (11a-11c, 13a-13c) is disclosed. The semiconductor switch elements (12a-12c), and cushion members (11a-11c, 13a-13c) are compressively interposed between the output wiring plate (4-6, 4'-6') and positive wiring plate (3), and also between the output wiring plate (4-6, 4'-6') and negative wiring plate (2), to thereby constitute bridge circuitry. The positive wiring plate (3), negative wiring plate (2), or output wiring plate (4-6, 4'-6') is for use as one support body of a pressurization structure. With such an arrangement, it is possible to improve the heat releasability of semiconductor elements while at the same time reducing the inductance of direct current (DC) circuitry to thereby suppress heat generation of the semiconductor elements, thus increasing the reliability relative to temperature cycles.

## Description

### BACKGROUND OF THE INVENTION

### FIELD OF THE INVENTION

The present invention relates generally to semiconductor devices and, more particularly, to a semiconductor device with heat generation suppressibility and enhanced heat releasability for improving the reliabilty relative to temperature cycles.

### DESCRIPTION OF THE RELATED ART

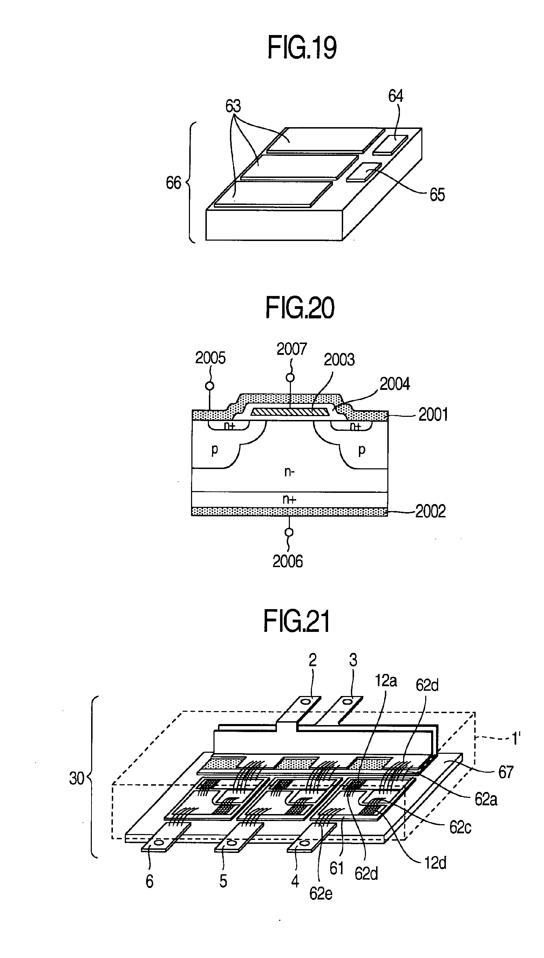

Fig. 21 is a diagram showing a parts-mounting structure of a prior known semiconductor device with built-in bridge circuitry including semiconductor switch elements. In this drawing, reference numeral "1" designates an enclosure called the package housing or simply casing; 2 denotes a negative polarity direct current (DC) wiring plate; 3 indicates a positive polarity DC wiring plate; 4 is a U-phase output terminal; 5, V-phase output terminal; 6, W-phase output terminal; 12a and 12d, semiconductor switches; 30, semiconductor device; 61, dielectric substrate; 62a, 62b, 62c, 62d, 62e, wiring leads; 67, heat radiation plate, also known as "heat sink." The semiconductor switches 12a, 12d have lower surface electrodes which are soldered onto a conductive pattern of the dielectric substrate 61 and also have upper surface electrodes to which the leads 62b, 62c are connected by bonding techniques. Dielectric substrate 61 is contacted by soldering to heat radiator plate 67. Although the semiconductor switches were explained with respect to a single-phase part of the bridge circuitry, the same goes with the remaining two phase parts. As shown in Fig. 21 this device is such that constituting three-phase bridge circuitry advantageously makes it possible to handle an electric power converter as a single circuit block.

Typically the semiconductor device experiences a certain amount of heat generation determinable by the resistance values of presently turned-on semiconductor switches making up the device (referred to hereinafter as turn-on resistivity) and by the values of currents flowing therein, and also heat generation occurring depending upon voltage/current values during turn-on and off operations of such semiconductor switches. Furthermore, in cases where specific semiconductor switches are employed each comprising a diode integral with a switch element, such as metal oxide semiconductor field effect transistors (MOSFETs), heat generation occurring due to a current flowing in such diode will be added thereto.

For the semiconductor device to function properly, it should be required that any possible temperature rise-up at the semiconductor switches due to these heat generation actions stated above be suppressed to less than or equal to a prespecified temperature level (referred to as the "maximal operating temperature" hereinafter) which guarantees proper operations of the semiconductor switches. Such temperature riseup may typically be suppressed by reducing the turn-on resistivity of a semiconductor switch at each arm or alternatively by reducing equivalent turn-on resistivity of parallel-connected semiconductor switches. The former approach is generally encountered with risks as to decreases in withstanding or breakdown voltage of semiconductor switches, which in turn strictly requires suppression of an increase in voltage being applied to a semiconductor switch during turn-off operations thereof to less than or equal to the breakdown level thereof. On the contrary, the latter approach suffers from increase in semiconductor switch mount area and also increase in wiring lead area, which would result in an increase in dimension of the semiconductor device.

In addition, due to the so-called temperature cycling occurring during start-up and shut-down of the semiconductor device due to the presence of differences in thermal expandabilities of constituent parts or components such as the semiconductor switches, dielectric substrate and heat sink plate or else, distortion can take place at soldered contact portions between the semiconductor switches and the dielectric substrate and also at wire-bonding portions of such semiconductor switches, which leads to creation and growth of cracks through repeated experience of the temperature cycle.

To improve the reliability of such semiconductor device, it is required to employ a specifically designed structure which lessens the distortion to thereby eliminate cracking. The known approach to reducing the distortion includes a method for designing the semiconductor device so that it is made of chosen materials less in thermal expandability differences, a method for reducing the heat generation at semiconductor switches per se to thereby lessen temperature changes, and a method of connecting together the large current-flowing semiconductor switches and their associated conductive wiring leads by pressurized or "compressive" contact therebetween with pressures applied thereto while eliminating the use of any solders and wires.

A semiconductor device employing such compressive contact scheme (pressure welding technique) is disclosed in Published Unexamined Japanese Patent Application No. 11-74456 (JP-A-11-74456). This semiconductor device as taught thereby includes semiconductor elements making up upper and lower arm parts and an alternate current (AC) side output conductor along with a positive polarity electrode plate and a negative electrode plate for supplying DC power supply to the upper and lower arms, which are interposed between heat radiation fins from both sides thereof with coned disc springs laid therebetween to thereby constitute a single-phase part of bridge circuitry. With such an arrangement, the need to contact by soldering between the semiconductor elements and electrode plates is avoided.

In recent years, the quest for larger current in power semiconductor devices grows rapidly while satisfying technical requirements for size reduction or miniaturization. In particular, advanced semiconductor devices with enhanced performance for achievement of large-current switchabilities do not come without accompanying penalties as to either soldering cracks or accidental bond-wire breaking due to thermal stresses in the way stated previously, resulting in a likewise decrease in lifetime thereof. Accordingly, a need is felt for such large-current semiconductor devices to retain the elements at well controlled temperatures less than or equal to a predefined value to thereby guarantee that the device will operate properly in any events.

### SUMMARY OF THE INVENTION

The present invention was made in view of the above points to provide a semiconductor device capable of improving heat releasability of semiconductor elements to thereby enhance the reliability relative to temperature cycles. Also provided is a semiconductor device capable of suppressing heat generation of the semiconductor elements by causing DC circuitry to decrease in inductance thereof.

To attain the foregoing objects the present invention employs specific means which follows.

In a semiconductor device including a positive polarity wiring plate, negative polarity wiring plate, more than one output wiring plate, one or more semiconductor switch elements and a conductive shock-absorbable buffering material with the semiconductor switch elements and the buffer material being compressively interposed between the output wiring plate and the positive polarity wiring plate and also between the output wiring plate and negative polarity wiring plate to thereby make up bridge circuitry, the positive polarity wiring plate, the negative polarity wiring plate or the output wiring plate is adaptable for use as one support member of a pressure applying or pressurization structure.

In accordance with this invention, it is possible to provide a semiconductor device capable of improving the semiconductor switch elements in heat releasability to thereby enhance the reliability with respect to temperature cycling. It is also possible to reduce the inductance of DC circuitry, thus suppressing or minimizing unwanted generation of heat at the semiconductor switch elements.

### BRIEF DESCRIPTION OF THE DRAWINGS

Fig. 1 is a diagram showing an electric power conversion apparatus to which the present invention may be applied.
Fig. 2 is a drawing showing a configuration of a three-phase AC outputting semiconductor device.
Fig. 3 is a diagram depicting a top plan view of the semiconductor device in accordance with a first embodiment of this invention.
Fig. 4 is a diagram showing a cross-sectional view of the device of Fig. 3 as taken along line A-A'.
Fig. 5 is a diagram showing a sectional view of the Fig. 3 device as taken along line B-B'.
Fig. 6 illustrates a top plan view of a semiconductor device in accordance with a second embodiment of the invention.
Fig. 7 is a diagram showing a sectional view of the device of Fig. 6 as taken along line A-A'.
Fig. 8 is a diagram showing a sectional view of the device taken along line B-B' shown in Fig. 6.
Fig. 9 shows a top plan view of a semiconductor device in accordance with a third embodiment of the invention.
Fig. 10 shows a sectional view of the device of Fig. 9 as taken along line A-A'.
Fig. 11 shows a top plan view of a semiconductor device in accordance with a fourth embodiment of the invention.
Fig. 12 shows a sectional view of the device of Fig. 11 as taken along line A-A'.
Fig. 13 depicts a sectional view of the device taken along line B-B' shown in Fig. 11.
Fig. 14 depicts a perspective view of a semiconductor device in accordance with a fifth embodiment of the invention.
Fig. 15 is a diagram showing a sectional view of the device of Fig. 14 as taken along plane XY.
Fig. 16 is a diagram showing an XZ sectional view of the device of Fig. 14.
Fig. 17 depicts a top perspective view of the semiconductor device in accordance with the second embodiment.
Fig. 18 is a pictorial representation of a land vehicle drive system.
Fig. 19 shows an electrode structure of a MOSFET.
Fig. 20 shows a sectional structure of the MOSFET.
Fig. 21 is a parts-mount structure of one prior art semiconductor device.

### DETAILED DESCRIPTION OF THE EMBODIMENTS

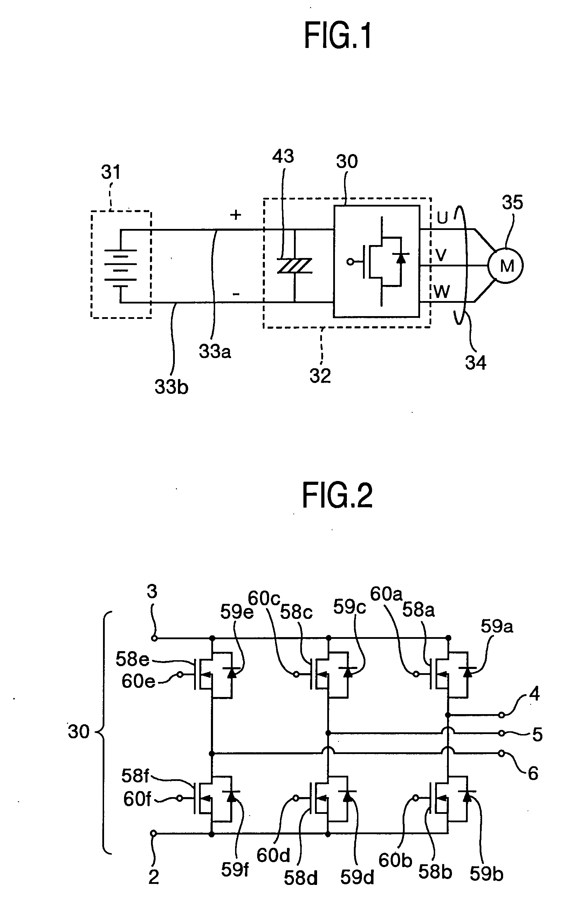

Fig. 1 depicts an electric power conversion apparatus which incorporates the principles of the present invention.

In this drawing, reference numeral "30" is used to designate a semiconductor device; 31 designates a direct current (DC) power supply unit; 32 denotes a power converter; 33a, 33b indicate main circuit wiring lines; 43 is an electrolytic capacitor; 34, output wiring lines; 35, electric motor. The semiconductor device 30 is formed of a power semiconductor switch element, such as a power metal oxide semiconductor field effect transistor (MOSFET), insulated-gate bipolar transistor (IGBT) or the like. Note here that electrical wiring lines within the power converter in which an output current flows along with wiring leads within the semiconductor device will collectively be called "main circuit wiring lines" hereinafter in the description.

The semiconductor device 30 receives at its input a DC voltage and then outputs a potentially variable AC voltage with variable frequency toward the output wiring lines 34 of the U, V and W phases to thereby drive the electric motor 35. The electrolytic capacitor 43 functions to suppress any possible variation in DC voltage otherwise occurring due to switching operations of the semiconductor device. In the power converter embodying the invention, the electrolytic capacitor 43 should not be limited only to the illustrative electrolytic capacitor and may be replaced with any other suitable capacitors with electrolytic capacitance values large enough to satisfy the in-use conditions required.

The power converter 32 also offers three-phase AC to DC convertibility while permitting the above-noted power converter to be used as a DC power supply if necessary. More specifically, two separate semiconductor devices 30 may be employed to drive the electric motor in such a way that one of them is used to convert an AC power supply voltage into a DC voltage and then the other semiconductor device is used to convert it to a three-phase AC voltage. The present invention relates to the semiconductor device 30 and, thus, is also applicable to other power converters that are designed to input the above-stated AC power supply voltage. To be brief, in cases where the DC power supply has a charge-up function, it is possible to electrically charge up the DC power supply by a method having the steps of letting the electric motor's rotary shaft rotate by application of external force thereto and then causing the semiconductor device 30 to convert the resultant AC power created at an output wiring line(s) into DC power.

See Fig. 2, which depicts a circuit configuration of the three-phase AC output semiconductor device 30 shown in Fig. 1. In this drawing, numeral 30 designates the semiconductor device; 58a, 58b, 58c, 58d, 58e and 58f denote semiconductor switches; 59a to 59f indicate diodes; 60a-60f are semiconductor switch control terminals; 3 is a positive polarity terminal; 2, negative polarity terminal; 4, U-phase output terminal; 5, V-phase output terminal; 6, W-phase output terminal, wherein these terminals 4-6 make up a single set of three-phase AC terminals. A DC voltage is applied between the positive terminal 3 and negative terminal 2. Note here that in Fig. 2, drive circuitry for driving semiconductor switch turn-on/off control signals is eliminated for purposes of convenience in illustration only.

The semiconductor switches 58a-58f may typically be power MOSFETs or IGBTs. In case these semiconductor switches are formed of power MOSFETs, the semiconductor switch 58a and its associative diode 59a may be integrated together into a single IC chip due to the fact that the power MOSFETs each include a diode in the device structure thereof. Accordingly, in case the semiconductor switches are formed of power MOSFETs, a need is avoided to mount the diodes as separate or "discrete" components.

As shown in Fig. 2, the semiconductor switch 58a and semiconductor switch 58b make up one side of a bridge; similarly, the semiconductor switches 58c-d constitute one bridge side. The same goes with the semiconductor switches 58e-f. A pulse width modulation (PWM) control signal voltage is applied to a respective one of the semiconductor switch control terminals 60a-60f for controlling the turn-on and off time period of a respective one of the bridge-connected semiconductor switches 58a-58f, thereby making it possible to supply the electric motor 35 with a potentially variable three-phase AC voltage with variable frequency.

Although the above explanation is specifically drawn to one exemplary three-phase bridge circuitry, similar results are also obtainable by use of three sets of half-bridge circuits each consisting essentially of the positive terminal 3, negative terminal 2, semiconductor switches 58a-b, and output terminal 6. In brief, the instant invention relates to the structure of DC wiring part that depends upon none of the requisite numbers of semiconductor switches and of bridge circuits used, and is applicable to any semiconductor devices comprising at least two controllable bridge-connected semiconductor switches, at least one output terminal and positive and negative DC terminals.

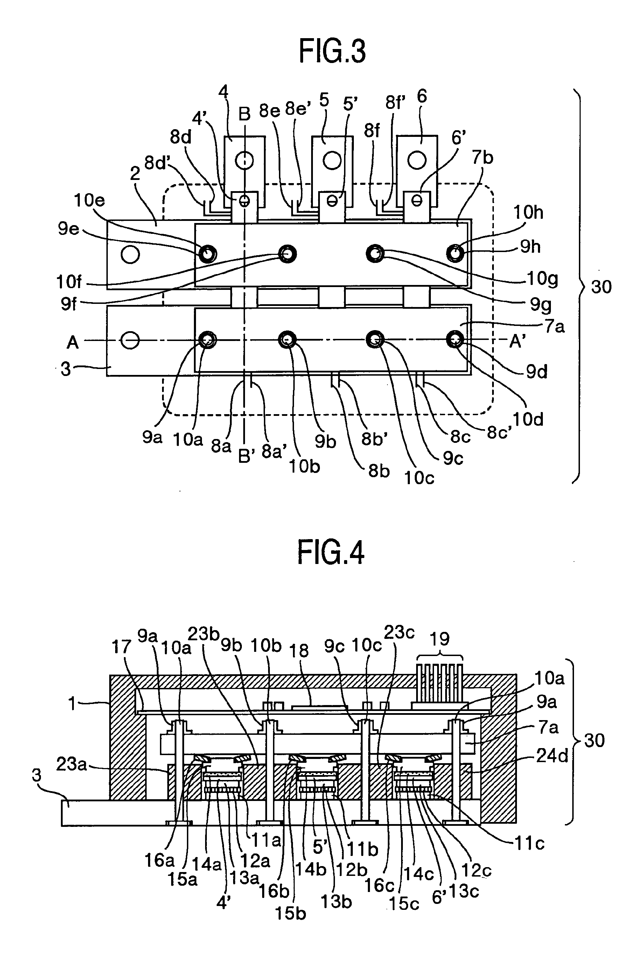

Several preferred embodiments of the invention will now be set forth in detail with reference to Figs. 3 through 20 below. Note that in these drawings, like parts are designated by like reference characters. Additionally semiconductor switch drive circuitry will be eliminated in the drawings for purposes of convenience in illustration. Only drive circuit board/substrate layouts are depicted therein.

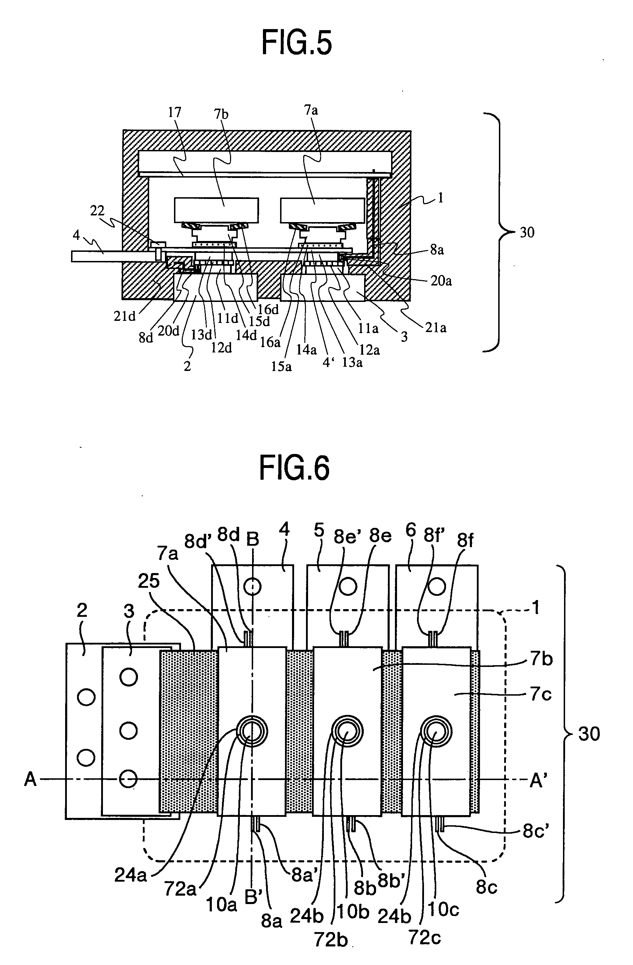

Figs. 3 to 5 are diagrams showing a semiconductor device in accordance with a first embodiment of the invention, wherein Fig. 3 depicts a top view; Fig. 4 is a cross-sectional view as taken along line A-A' of Fig. 3; and, Fig. 5 is a sectional view taken along line B-B' in Fig. 3. In Fig. 3, numeral 1 designates a package housing or casing; 2 denotes a negative polarity DC wiring board or plate; 3 is a positive polarity DC wiring plate; 4, 5, 6, 4', 5' and 6' are output wiring plates; 7a-7b, pressure applying or "pressurization" plates; 8a to 8f and 8a'-8f', signal transfer lines formed of electrical leads; 9a-9f, collars; 10a-10f, bolts; 30, semiconductor device. Each DC terminal 2, 3 is provided with a through-going hole for wiring attachment to a DC power supply unit. Respective output wiring plates 4-6 are provided holes for output wiring attachment. Signal wiring leads as used herein are organized into pairs; for example, wiring leads 8a and 8a' are designed as a pair with one being connected to the gate electrode of a MOSFET constituting a semiconductor switch and with the other connected to the source electrode thereof. Note that the invention should not be limited only to the "paired signal line combination" feature relative to the signal lines for connection to the semiconductor switches. For instance, in cases where the semiconductor switches used offer built-in functions for temperature detection or current detection or the like, extra signal transfer leads for either temperature detection signals or current detection will additionally be required.

In Fig. 4, numeral 1 designates the casing; 3 denotes positive DC wiring plate; 4' to 6', output wiring plates; 9a-9d, collars; 10a-10d, bolts; 11a-11c, shock-absorbable buffer materials or "cushion" members; 12a-12c, semiconductor switches; 13a-13c, cushions; 14a-14c, insulators made of chosen dielectric material; 15a-15c, pressurization plates; 16a-16c, coned disc springs; 17, driver circuit board or substrate; 18, electronics component(s); 19, signal terminal; 23a-23d, molded frames; 30, semiconductor device. The coned disc springs 16a-16c are the ones each of which is formed of a hollow disk or ring-like plate as machined into a circular cone shape. The device structure shown in Fig. 4 is designed to employ MOSFETs as the semiconductor switches, wherein a combination of semiconductor switch and diode is shown as a single component.

A MOSFET electrode structure is shown in Fig. 19. In Fig. 19, numeral 63 designates source electrodes; 64 denotes a gate signal-input source electrode that is the same in potential as the source electrodes 63; 65 is a gate signal electrode; 66, a MOSFET chip. A sectional structure of MOSFET is shown in Fig. 20. As shown herein, a drain electrode 2002 is formed on a surface opposing the source electrode 2001 of the MOSFET chip. A source electrode 2001 and a drain electrode 2002 are made of electro-conductive material such as metal. The source electrode 2001 and the drain electrode 2002 are connected to a source terminal 2005 and a drain terminal 2006, respectively. A gate electrode 2003 made of electro-conductive material such as N+ polysilicon and so forth is electrically insulated from the source electrode 2001 by a gate insulation film 2004 made of electro-conductive material such as silicon oxide film-and so forth. The gate electrode 2003 is connected to a gate terminal 2007. These electrodes are assembled so that the cushion member 11a and the drain electrode of semiconductor switch 12a are brought into contact with each other while letting cushion 13a and the source electrode of semiconductor switch 12a come into contact with each other as exemplarily shown in Fig. 4. Additionally the contact surface of cushion 13a is formed so that it is substantially the same in size as the source electrode surface.

An explanation will next be given of a pressure-applied or pressurized connection structure of the positive DC wiring plate 3, semiconductor switch 12a and output wiring plate 4' with reference to Fig. 4. An assembly with lamination of the cushion 11a, semiconductor switch 12a, cushion 13a, output wiring plate 4', insulator 14a, pressurization plate 15a and coned disc spring 16a is interposed between the positive DC wiring plate 3 and pressurization plate 7a while letting the bolts 10a-10d and collars 9a-9d apply pressure between the positive DC wiring plate 3 and pressure plate 7a. Screw threads are provided at coupling portions of bolts 10a-10d with collars 9a-9d for pulling bolts 10a-d by oil pressures or else to the extent that the requisite pressurization force is established while squeezing collars 9a-d from outside thereof to thereby form specific shapes resembling the screw threads inside the collars for coupling the bolts and collars together. With this scheme, it is possible to apply any required pressures with increased accuracy. As shown in the illustrative embodiment, the cushion 11a, semiconductor switch 12a, cushion 13a, output wiring plate 4', insulator 14a and pressure plate 15a may be appropriately position-determined by the mold frames 23a-b whereas coned disc spring 16a is well adjustable in position by pressure plate 15a. In this embodiment with three semiconductor switches pressurized by use of four bolts, a weight or load of approximately 77 kgf per bolt will be applied in case the semiconductor switch with its electrode area of 1 square centimeter is pressurized at 10 MPa. In this case, in light of JIS B1051-1991 (ISO898-1) standards, the use of steel bolts with a strength class of 5.8 results in achievement by bolts with diameters of 2.4 mm or greater from a guaranteed weight stress of 38.7 kgf/mm². Additionally this invention should not be limited to the approach to pressurization of the positive DC wiring plate 3 and semiconductor switch 12a plus output wiring plate 4' by using the bolt/collar combination: the collars are replaceable by nuts when the need arises. Using such pressurization mechanism including bolts 10a-10d and collars 9a-d for pressurization of a structural body lying between the positive DC wiring plate 3 and pressure plate 7a makes it possible to successfully connect between the positive DC wiring plate 3 and the drain electrode of semiconductor switch 12a via cushion member 11a while connecting between the source electrode of semiconductor switch 12a and output wiring plate 4 via cushion 13a.

The coned disc springs 16 are used for retaining the required pressure irrespective of variations in size occurring―due to with-time changes and/or thermal expandabilities caused by semiconductor switch heat generation―at the cushion member 11a, semiconductor switch 12a, cushion 13a, output wiring plate 4', insulator 14a, pressure plate 15a, positive DC wiring plate 3, pressure plate 7a, bolts 10a-10d, collars 9a-d and others.

It should be noted that due to the fact that the coned disc springs are inherently less in contact surface area for heat transmission and thus significant in thermal resistivity, the illustrative embodiment is specifically arranged so that the coned disc springs are disposed on one side only, thus forcing heat generated at the semiconductor switches to reach the positive DC wiring plate 3 through cushion 12a to be finally transferred toward an associative refrigerating or cooling unit from the positive DC wiring plate 3 through the insulator(s). Additionally in case the above-noted size changes can become greater than the coned disc springs' allowable deflection amount, this is avoidable by use of a serial combination of multiple coned disc springs.

In the illustrative structure a silver sheet may be inserted between the cushion 13a and output wiring plate 4' in order to increase the uniformity of pressures as applied to the cushion 11a and semiconductor switch 12a plus cushion 13a. Alternatively in case the cushion members are made of molybdenum (Mo) nearly equal to silicon in thermal expandability, adjacent ones of cushion 11a, semiconductor switch 12a and cushion 13a may be contacted by soldering together. Preferably the insulator 14a is formed into a plate shape or sheet-like shape.

The foregoing discussion is directed to the pressurized or "compressive" connection structure of the positive DC wiring plate 3 and semiconductor switch 12a plus output wiring plate 4', the same goes with a compressive connection structure of positive DC wiring plate 3 and semiconductor switch 12b plus output wiring plate 5' in combination and also with a compressive connection structure of a combination of positive DC wiring plate 3 and semiconductor switch 12c plus output wiring plate 6'.

In Fig. 5, numeral 1 designates the casing; 2 denotes negative DC wiring plate; 3 indicates positive DC wiring plate; 4, 4' are output wiring plates; 8a, 8d are switching signal leads; 11a, 11d, buffering or cushion members; 12a, 12d, semiconductor switches; 13a, 13d, cushions; 14a, 14d, insulators; 15a, 15d, pressurization plates; 16a, 16d, coned disc springs; 17, drive circuit board or substrate; 20a, 20d, spring pin connectors; 21a, 21d, molded components with switching leads being embedded therein; 22, screw(s); 30, semiconductor device.

As shown Fig. 5 the output wiring plates 4, 4' are electrically connected together by more than one screw 22. Additionally with the invention, the method for connection of the output wiring plates 4, 4' should not be limited to the screwing technique stated above and may alternatively be modified to employ soldering or brazing connection techniques if necessary. Optionally the output wiring plates 4, 4' are alterable so that they are integrated together.

It must be noted here that as in the compressive connection structure of the positive DC wiring plate 3 and semiconductor switch 12a plus output wiring plate 4' as set forth in conjunction with Fig. 4, the compressive connection structure of the negative DC wiring plate 2 and semiconductor switch 12d plus output wiring plate 4' is designed so that an assembly with lamination of the cushion member 11d, semiconductor switch 12d, cushion 13d, output wiring plate 4', insulator 14d, pressurization plate 15d and coned disc spring 16d is interposed between the negative DC wiring plate 2 and pressure plate 7b while letting bolts 10e-10h and collars 9e-h apply pressure between the negative DC wiring plate 2 and pressure plate 7d.

An explanation will next be given of the mount structure of signal transfer leads for connection to the semiconductor switch 12a with reference to Fig. 5. A signal lead 8a is embedded in a molded component 21a and is connected to spring pin connector 20a. Part of the molded component 21a which is interposed between an output wiring plate 4' and semiconductor switch 12a is less in thickness than a cushion member 13a. The spring pin connector 20a has its distal end which is in electrical contact with the gate electrode of semiconductor switch 12a due to sliding movement of the spring pin connector 20a.

With regard to other signal electrodes provided at the semiconductor switch 12a, these are electrically connected similarly by the spring connector and signal leads which are embedded in the molded component 21a. In addition the signal leads are connected to circuitry of the drive circuit substrate 17. It should be noted that the semiconductor device of this invention should not be limited to the one that has its built-in drive circuit substrate and may also be applied to those with externally connectable drive circuitry; if this is the case, similar results are obtainable by designing the signal leads so that these extend up to outside of the casing and are designed as connector pins for receiving input signals externally supplied thereto.

Next, a mounting structure of switching signal transmission leads for connection to a semiconductor switch 12d will be explained below. The semiconductor switch 12d is disposed so that its drain electrode surface and source electrode surface are inverted with respect to those of the semiconductor switch 12a. Due to this, signal terminals including a gate terminal are present on the lower surface side whereby a molded component 21d with a spring pin connector 20d and a switching signal lead 8d connected to the spring pin connector 20d being embedded therein has a shape corresponding to the layout discussed above. Owing to the molded component 21d, the semiconductor switch 12d's gate electrode and the signal lead 8d are electrically connected together in a similar way to that of the molded component 21a.

The semiconductor device embodying the invention may be mounted or built into an electric power converter while permitting lower surfaces of the negative DC wiring plate 2 and positive DC wiring plate 3 to come into contact with a cooler such as cooling fins made of chosen conductive material with a thin layer of dielectric material sandwiched therebetween. With such an arrangement, it becomes possible, upon occurrence of a change in current flowing in the negative DC wiring plate 2 and positive DC wiring plate 3, to permit a current of the reverse direction to flow in conductive surfaces of the cooling fins as disposed opposing the negative DC wiring plate 2 and positive DC wiring plate 3. This in turn makes it possible to reduce the inductance values of such negative DC wiring plate 2 and positive DC wiring plate 3.

As has been set forth above, in accordance with this embodiment, it becomes possible to use those semiconductor switches with much less turn-on resistivities and thus having lower withstanding or breakdown voltage levels, which in turn makes it possible to suppress heat generation at such semiconductor switches. In addition, the heat generation suppressibility makes it possible to reduce the pressurization force required to obtain desired contact heat resistivity for letting semiconductor switch temperatures stay less than or equal to a maximal operating temperature while at the same time enabling downsizing and reduction in complexity of the pressurization mechanism involved. Furthermore, the inductance reducibility leads to achievement of an effect for suppressing heat production depending on voltage/current values during turn-off operations of the semiconductor switches.

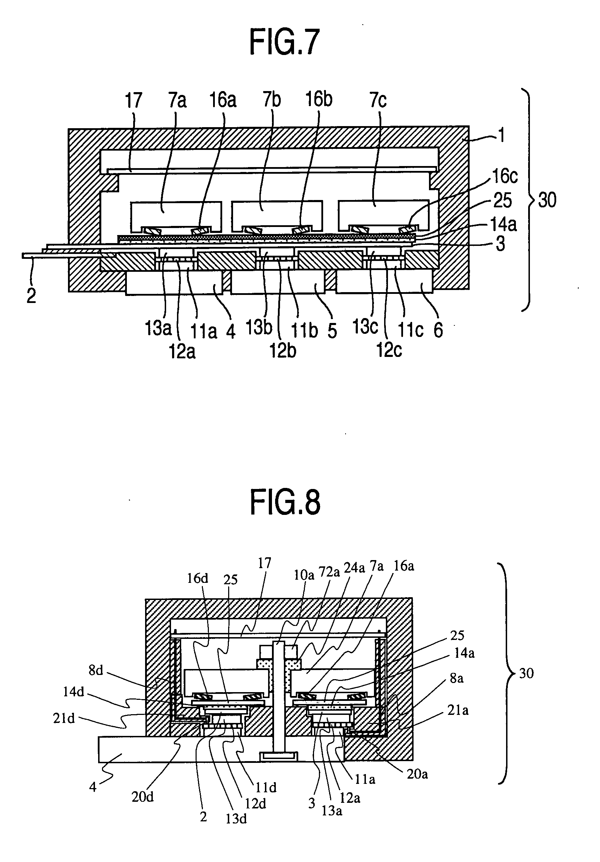

Figs. 6 to 8 are diagrams showing a semiconductor device in accordance with a second embodiment of the invention, wherein Fig. 6 is a top plan view, Fig. 7 is a sectional view taken along line A-A' of Fig. 6, and Fig. 8 is a sectional view along line B-B' of Fig. 6. In Fig. 6, reference character 1' designates a casing; 2 denotes a negative DC wiring plate; 3 is a positive DC wiring plate; 4 to 6, output wiring plates; 7a-7c, pressurization plates; 8a-8f and 8a'-8f', signal transmission lines formed of conductive wiring leads; 10a-10c, bolts; 72a-72c, nuts; 24a-c, insulators; 25, printed wiring plate; 30, semiconductor device. Each wiring plate 2, 3 is provided with openings or holes for lead attachment to the DC power supply. Each output wiring plate 4, 5, 6 has a hole for output lead attachment. The signal leads are organized into pairs; for example, leads 8a and 8a' are paired for connection to the gate electrode and source electrode of a MOSFET for use as one semiconductor switch.

In Fig. 7, 1 indicates a casing; 2 designates negative DC wiring plate; 3 denotes positive DC wiring plate; 4-6 are output wiring plates; 25, wiring plate; 11a-11c, buffering or "cushion" members; 12a-12c, semiconductor switches; 13a-13c, cushion members; 14a-14c, insulators; 16a-c, coned disc springs; 17, drive circuit substrate; 19, signal terminal; 23a-23d, mold frames; 25, wiring plate; 30, semiconductor device.

In Fig. 8, 1 denotes the casing; 2 is negative DC wiring plate; 3, positive DC wiring plate; 4, output wiring plate; 8a and 8d, signal leads; 10a, bolt; 72a, nut; 11a, 11d, buffer or cushion members; 12a, 12d, semiconductor switches; 13a, 13d, cushions; 14a, 14d, insulators; 16a, 16d, coned disc springs; 17, drive circuit substrate; 20a, 20d, spring pin connectors; 21a, 21d, mold components with signal leads embedded therein; 25, wiring plate; 30, semiconductor device.

An explanation will be given of the pressurized or "compressive" connection mechanism in the illustrative embodiment. As shown in Figs. 6-8, the compressive connection mechanism is arranged so that each semiconductor switch of two arms making up one phase of bridge circuitry and its associated wiring lead(s) are compressively connected together by use of a single bolt. In Fig. 8 an assembly with lamination of the cushion member 11a, semiconductor switch 12a, cushion 13a, negative DC wiring plate 3, insulator 14a, wiring plate 25 and coned disc spring 16a and a stacked assembly of cushion 11d, semiconductor switch 12d, cushion 13d, positive DC wiring plate 2, insulator 14d, wiring plate 25 and coned disc spring 16d are interposed between the output wiring plate 4 and the pressurization plate 7a while simultaneously causing the bolt 10a and nut 72a to pressurize by a clamping force thereof between the output wiring plate 4 and pressure plate 7a. The insulator 24a is provided between the bolt 10a and nut 72a for electrical isolation 24a between adjacent ones of the output wiring plates 4-6. Optionally the nuts may be replaced by collars for providing similar pressure application scheme to the first embodiment stated supra.

An explanation will next be given of the mount structure of signal leads for connection to the semiconductor switch 12a in this embodiment. In Fig. 8 the mold component 21a is such that a signal lead 8a being connected to the spring pin connector 20a is embedded therein. In this component 21a, its part that is interposed between the positive DC wiring plate 3 and semiconductor switch 12a is less in thickness than the cushion 13a. The spring pin connector 20a has its distal end which is in electrical contact with the gate electrode of semiconductor switch 12a due to sliding movement of the spring pin connector 20a. As per the other signal electrodes as provided at the semiconductor switch 12a, these are electrically connected by the spring connector and signal leads being embedded in the molded component 21a. The signal leads are connected to circuitry of the drive circuit substrate 17. A mount structure of switching signal leads for connection to a semiconductor switch 12d will be explained below. The semiconductor switch 12d is disposed so that its drain electrode surface and source electrode surface are inverted with respect to those of the semiconductor switch 12a. Due to this, signal terminals including a gate terminal are present on the upper surface side whereby a molded component 21d with a spring pin connector 20d and a switching signal lead 8d connected to the spring pin connector 20d being embedded therein has a shape corresponding to the layout discussed above. Owing to the molded component 21d, the semiconductor switch 12d's gate electrode and the signal lead 8d are electrically connected together in a similar way to that of the molded component 21a. Although the spring pin connector-employed gate wiring structure has been explained above, the spring pin connectors may be replaced by conductive pins each having a spirally wound distal end and thus offering spring functionality.

Note that the pressure applying structure of certain portions at which respective pressurization plates 7b, 7c are compressively connected and the signal lead mounting structure are similar to that at part whereat the above-noted pressure plate 7a is connected compressively. Also note that in this embodiment, two adjacent semiconductor switches are built into the compressive connection mechanism by using a pair of bolt and but, resulting in achievement of a uniform area pressure-realizable structure while accompanying a penalty as to an increase in required bolt diameter when compared to the first embodiment. Furthermore with this embodiment, disposing the coned disc springs on one side only permits establishment of a route or path for transferring heat generated at semiconductor switches through the cushions 12a, 12d toward the output wiring plate 4 and then transferring it from output wiring plate 4 via the insulator(s) to the cooler such as cooling fins.

Unlike the first embodiment, the second embodiment becomes weak in inductance reduction effects due to a flow of eddy currents in proximity conductor surfaces with cooling fins or the like externally attached thereto; in view of this, a single wiring plate 25 is disposed in close proximity to the positive DC wiring plate 3 and negative DC wiring plate 2 with dielectric material sandwiched therebetween as shown in Figs. 7 and 8. Whereby, it is possible to realize inductance reducibility similar to that of the first embodiment. Additionally as shown in Figs. 6-7, a specific structure is employed in which the positive DC wiring plate 3 and negative DC wiring plate 2's portions for attachment of wiring leads to the DC power supply are stacked over each other while letting width-increased wiring plates interpose an insulator between adjacent ones of them. Designing the DC power supply-side wiring leads into such a multilayer lamination structure makes it possible to further reduce the inductance values at the portions for lead attachment to the DC power supply.

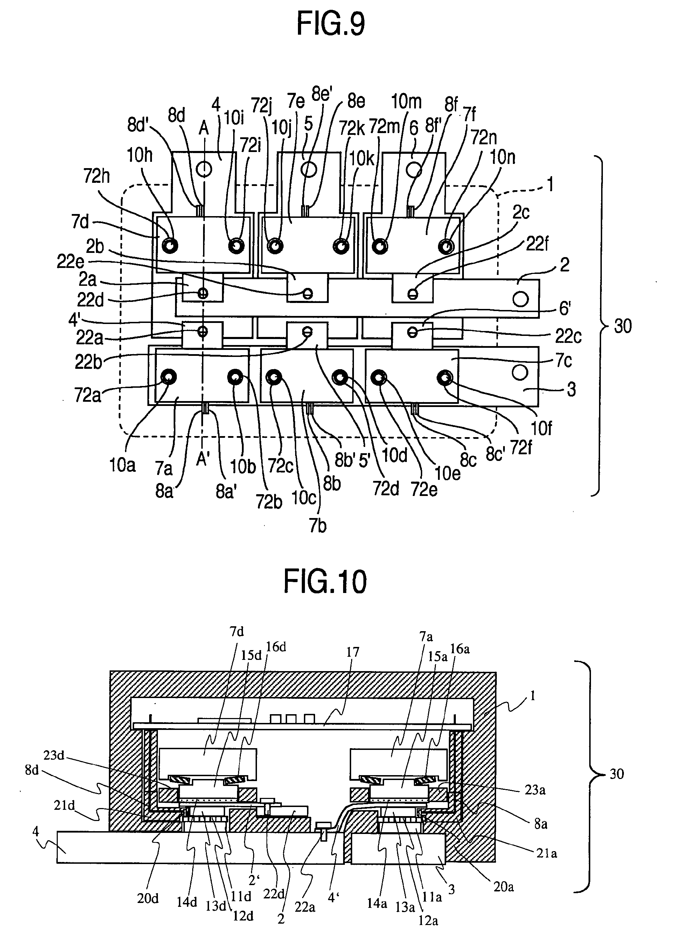

Figs. 9 and 10 are diagrams showing a semiconductor device in accordance with a third embodiment of the invention, wherein Fig. 9 is a top plan view, and Fig. 10 is a sectional view taken along line A-A' of Fig. 9. In Fig. 9, reference character 1' designates a casing; 2 and 2a-2c denote negative DC wiring plates; 3 is a positive DC wiring plate; 4-6 and 4'-6', output wiring plates; 7a-7f, pressurization plates; 8a-8f and 8a'-8f', signal transmission lines formed of wiring leads; 10a-10k and 10m-10n, bolts; 72a-72k and 72m-n, nuts; 22a-f, screws; 30, semiconductor device. Each wiring plate 2, 3 is provided with more than one hole for lead attachment to the DC power supply. Output terminals of the wiring plates 4-6 are provided with holes for output lead attachment. The signal leads are organized into pairs; for example, leads 8a and 8a' are paired for connection to the gate electrode and source electrode of a MOSFET for use as one semiconductor switch.

In Fig. 10, 1 indicates the casing; 2, 2' designate negative DC wiring plates; 3 denotes positive DC wiring plate; 4, 4' are output wiring plates; 7a, 7d, pressurization plates; 11a, 11d, buffer or "cushion" members; 12a, 12d, semiconductor switches; 13a, 13d, cushion members; 14a-c, insulators; 15a-c, pressurization plates; 16a, 16d, coned disc springs; 17, drive circuit substrate; 20a, 20d, spring pin connectors; 21a, 21d, mold components with signal leads embedded therein; 22a, 22d, screws; 23a, 23d, mold frames; 30, semiconductor device.

An explanation will be given of a compressive connection mechanism in the illustrative embodiment. As shown in Figs. 9-10 the compressive connection mechanism is provided per arm of the bridge circuitry. A stacked assembly of the cushion member 11a, semiconductor switch 12a, cushion 13a, output wiring plate 4', insulator 14a, pressurization plate 15a and coned disc spring 16a is interposed between the positive DC wiring plate 3 and the pressure plate 7a while simultaneously causing the positive DC wiring plate 3 and pressure plate 7a to be pressurized therebetween by the clamping forces of bolts 10a-10b and nuts 72a-b. Optionally the nuts may be replaced with collars to obtain similar pressure application results to the first embodiment stated supra.

Next, an explanation will be given of the mount structure of signal leads for connection to the semiconductor switch 12a in this embodiment. In Fig. 10 the mold component 21a is such that a signal lead 8a being connected to the spring pin connector 20a is embedded therein. In this component 21a, its part that is interposed between the positive DC wiring plate 3 and semiconductor switch 12a is less in thickness than the cushion 13a. The spring pin connector 20a has its distal end which is in electrical contact with the gate electrode of semiconductor switch 12a due to sliding movement of the spring pin connector 20a. Regarding the other signal electrodes as provided at the semiconductor switch 12a, these are electrically connected by the spring connector and signal leads being embedded in the molded component 21a. The signal leads are connected to circuitry of the drive circuit substrate 17. Unlike the first and second embodiments, the semiconductor switch 12d is structured so that the semiconductor switch is not inverted. Thus the signal lead mount structure is the same as the structure at the semiconductor switch 12a.

As stated above, this embodiment is the semiconductor device structure in which the semiconductor switch is not inverted. Due to this, thermal resistivity reduction is realized by letting the drain electrode greater in area than the source electrode of semiconductor switch be directed toward the heat release path side.

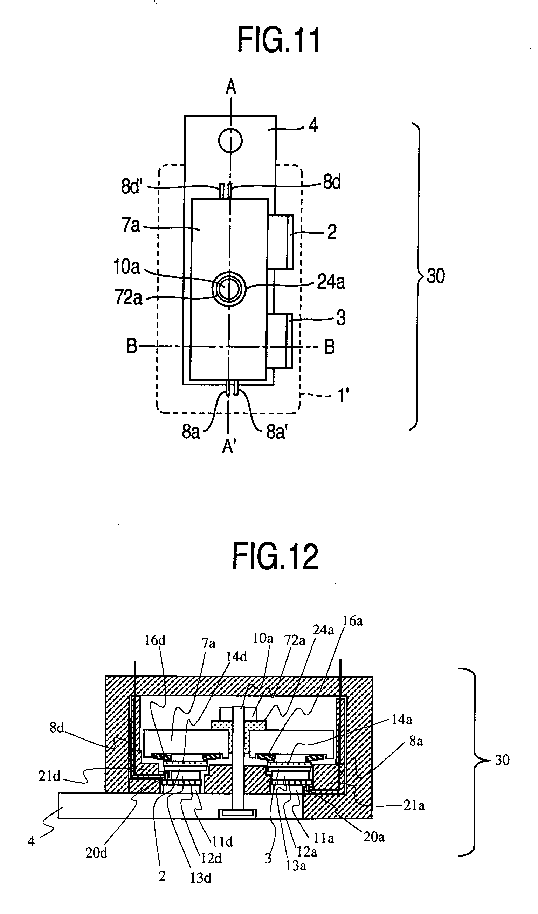

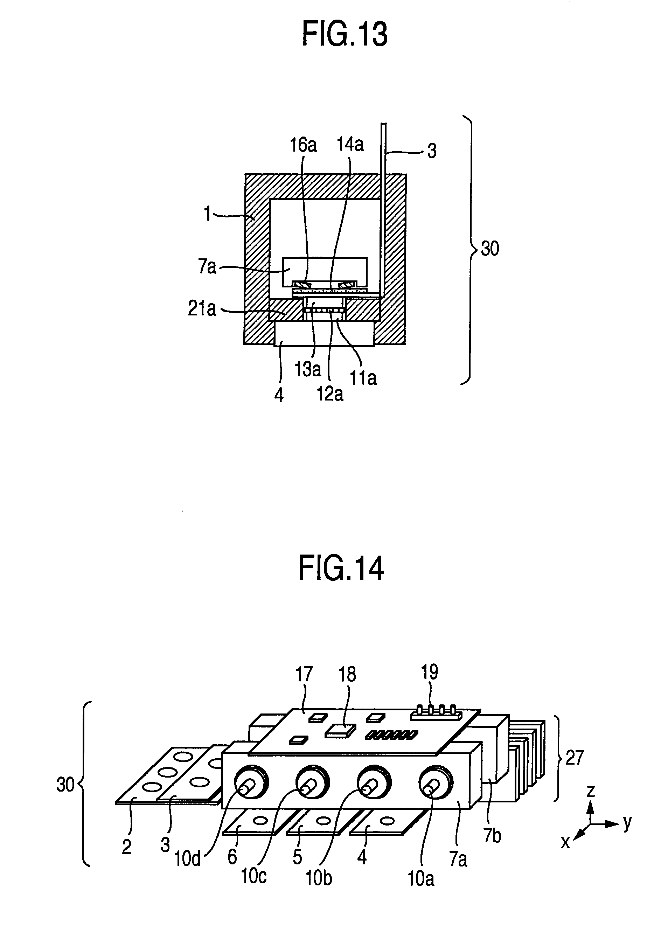

Figs. 11 to 13 are diagrams showing a semiconductor device in accordance with a fourth embodiment of the invention, wherein Fig. 11 is a top plan view, Fig. 12 is a sectional view taken along line A-A' of Fig. 11, and Fig. 13 is a sectional view along line B-B' of Fig. 11. In Fig. 11, reference character 1' designates a casing; 2 denotes a negative DC wiring plate; 3 is a positive DC wiring plate; 4, output wiring plate; 7a, pressurization plate; 8a, 8d, 8a', 8d', signal transmission lines formed of wiring leads; 10a, bolt; 72a, nut; 24a, insulator; 30, semiconductor device. Each wiring plate 2, 3 is provided with more than one hole for lead attachment to the DC power supply. The output wiring plate 4's terminal is provided with a hole for output lead attachment. The signal leads are organized into pairs; for example, leads 8a and 8a' are paired for connection to the gate electrode and source electrode of a MOSFET for use as one semiconductor switch.

In Fig. 12, 1 designates the casing; 2 denotes the negative DC wiring plate; 3 is the positive DC wiring plate; 4, output wiring plate; 7a, pressurization plate; 10a, bolt; 72a, nut; 11a, cushion member; 12a, semiconductor switch; 13a, cushion; 14a, insulator; 16a, coned disc spring; 20a, 20d, spring pin connectors; 21a, 21d, mold components with signal leads embedded therein; 24a, insulator; 30, semiconductor device.

In Fig. 13, 1 denotes the casing; 3, positive DC wiring plate; 4, output wiring plate; 7a, pressurization plate; 11a, cushion member; 12a, semiconductor switch; 13a, cushion; 14a, insulator; 16a, coned disc spring; 21a, mold component with signal leads embedded therein; 30, semiconductor device.

As readily seen from viewing Figs. 11-13, this embodiment is similar in structure to the second embodiment with one phase part of bridge circuit being deleted. Accordingly, the compressive connection mechanism and signal lead mounting structure of this embodiment is substantially the same as those used in the second embodiment. Additionally in this embodiment, the negative DC wiring plate 2, positive DC wiring plate 3 and signal transmission leads 8a, 8d, 8a', 8d' are such that terminals are provided on the top surface of semiconductor device 30. Using three separate semiconductor devices each having such arrangement makes it possible to constitute a three-phase AC output power converter. In addition, designing the constituent components into a module on a per-phase basis in this way facilitates replacement upon occurrence of malfunction while improving production yields in the manufacture of apparatus. Furthermore, using two similar semiconductor devices enables constitution of a single-phase AC output power converter.

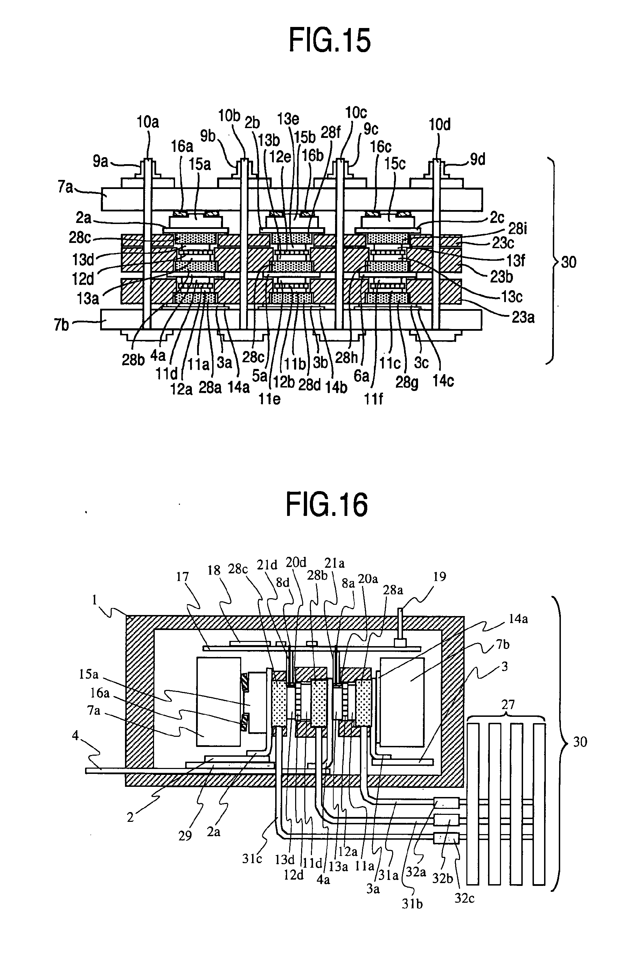

Figs. 14 to 16 show a semiconductor device in accordance with a fifth embodiment of the invention, wherein Fig. 14 is a perspective view, Fig. 15 is a sectional view as taken along X-Y plane of Fig. 14, and Fig. 16 is a sectional view as taken along X-Z plane of Fig. 16. In Fig. 14, numeral 2 designates a negative DC terminal; 3 denotes a positive DC terminal; 4-6 indicate output wiring plates; 7a-7b are pressurization plate; 9a-9d, collars; 10a-10d, bolts; 17, drive circuit substrate; 18, electronics component; 19, signal terminal; 27, heat release/radiation fins; 30, semiconductor device. This embodiment is arranged in structure so that built-in heat pipes are employed for suppressing the thermal resistivity of part covering from the semiconductor switch(es) up to cooler unit.

An explanation will next be given of the structure of a compressive connection mechanism in conjunction with Fig. 15. In Fig. 15, reference characters 2a-2c denotes negative DC wiring plates; 3a-3c designate positive DC wiring plates; 4a, 5a, 6a are output wiring plates; 7a-7b, pressurization plates; 9a-9d, collars; 10a-10d, bolts; 11a-11f, buffering or "cushion" members; 12a-12f, semiconductor switches; 13a-13f, cushions; 14a-14c, insulators; 15a-c, pressurization plates; 16a-c, coned disc springs; 17, drive circuit substrate; 18, electronics component; 19, signal terminal; 23a-d, mold frames; 25, wiring plate; 28a-i, conductive blocks with heat-receiving portions of heat pipes being built therein; 30, semiconductor device. In Fig. 15, a stacked assembly of the insulator 14a, positive DC wiring plate 3a, conductive block 28a with heat pipe's heat receive portion being built therein, cushion member 11a, semiconductor switch 12a, cushion 13a, output wiring plate 4a, conductive block 28b with heat pipe's heat receive portion built therein, cushion 11d, semiconductor switch 12d, cushion 13d, conductive block 28c with heat pipe's heat receive portion being built therein, negative DC wiring plate 2a, pressurization plate 15a and coned disc spring 16a, and a stacked assembly of the insulator 14b, positive DC wiring plate 3b, conductive block 28d with heat pipe's heat receive portion being built therein, cushion member 11b, semiconductor switch 12b, cushion 13b, output wiring plate 5a, conductive block 28e with heat pipe's heat receive portion being built therein, cushion 11e, semiconductor switch 12e, cushion 13e, conductive block 28f with heat pipe's heat receive portion being built therein, negative DC wiring plate 2b, pressure plate 15b and coned disc spring 16b, and also a stacked assembly of the insulator 14c, positive DC wiring plate 3c, conductive block 28g with heat pipe's heat receive portion being built therein, cushion 11c, semiconductor switch 12c, cushion 13c, output plate 6a, conductive block 28h with heat pipe's heat receive portion being built therein, cushion 11f, semiconductor switch 12f, cushion 13f, conductive block 28i with heat pipe's heat receive portion being built therein, negative DC wiring plate 2c, pressure plate 15c and coned disc spring 16c are interposed between the pressure plate 7a and the pressure plate 7b while at the same time causing the collars 9a-9d and bolts 10a-d to apply pressure between these plates 7a and 7b. Optionally the collars are replaceable by nuts to obtain similar pressurization results.

Next, a cooling structure in this embodiment will be set forth with reference to Fig. 16. In this drawing, numeral 1 designates the casing; 2, 2a denote negative DC wiring plates; 3, 3a, positive DC wiring plates; 4, 4a, output wiring plates; 7a-7b, pressurization plates; 8a, 8d, signal transmission leads; 11a, 11d, cushion members; 12a, 12d, semiconductor switches; 13a, 13d, cushions; 14a, insulator; 15a-15c, pressurization plates; 16a-c, coned disc springs; 17, drive circuit board; 18, electronics component; 19, signal terminal; 20a, 20d, spring pin connectors; 21a, 21d, molded components with signal leads embedded therein; 23a-b, mold frames; 25, wiring plate; 27, heat radiation fins; 28a-c, conductive blocks with heat pipes' heat receive portions being built therein; 29, dielectric sheet; 30, semiconductor device; 31a-c, heat pipes; 32a-c, dielectric pipes. In this drawing the negative DC wiring plates 2 and 2a are electrically connected together by more than one screw or the like. The same goes with the positive DC wiring plates 3 and 3a and also with output wiring plates 4 and 4a. Additionally the semiconductor switch 12a's gate electrode and the drive circuit board 17 are connected by the molded component 21a in which the signal lead 8a for connection to the spring pin connector 20a is embedded. Similarly the semiconductor switch 12d's gate electrode and the drive circuit board 17 are connected by the molded component 21d with the signal lead 8d for connection to the spring pin connector 20d being embedded therein.

As shown herein, the semiconductor switch 12a is interposed or "sandwiched" between the conductive blocks 28a, 28b with built-in heat pipe's heat receive portion via respective ones of the cushion member 11a and cushion 13a. Heat as generated at the semiconductor switch 12a is expected to escape to the outside along a heat radiation path including the following steps (1) to (3):
(1) Heat generated at the semiconductor switch 12a is transferred through cushion members 11a, 13a toward the conductive blocks 28a-28b with built-in heat pipe's heat receive portions, thereby evaporating activation liquids of such heat pipes' heat receive portions. In such event, vapor behaves to receive the heat generated at semiconductor switch 12a as evaporation latent heat.
(2) The activation liquid's vapor moves and migrates within the heat pipes resulting in condensation at condensing part of the heat pipes with the heat radiation fins coupled thereto. During such condensation the vapor dumps condensate latent heat to the heat radiation fins.
(3) The heat radiation fins externally release the heat received.

It should be noted that the liquid condensed at the step (2) above will flow to return at the heat receive portions by the wick action of heat pipe inner walls having a function of letting the activation liquid retain and reflow for circulation by utilization of the capillary action, also known as capillarity. The heat radiation means using such heat pipes features in increased heat transportability, rapid thermal responsibility, and enhanced ability to separate between the heat receive portions and cooling portions, and thus is an effective heat release scheme even where the conductive blocks 28b-c with built-in heat pipes' heat receive portions are less in heat receive areas. Examples of a combination of materials of the heat pipes and the activation liquid are copper and water, aluminum and alternative flon or equivalents thereto. Note that the present invention should not be limited only to such heat-pipe/activation-liquid material combinations.

Regarding the outward heat release path for the heat as generated at the semiconductor switch 12d also, such heat is transferable from the conductive blocks 28b, 28c with heat pipes' heat receive portion being built therein toward the heat radiation fins 27 in a similar way to that of the heat generated at the above-noted semiconductor switch 12a.

In the first to fourth embodiment stated supra, heat generated at the semiconductor switches is to be passed to the cooling fins with the cushion(s) and wiring plate(s) plus insulator(s) being as part of the heat release path. In contrast thereto, this embodiment is such that more than one conductive block with built-in heat pipe's heat receive portion is assembled into the compressive connection structure as a conductor that permits flow of a main current therein, thereby achieving successful transportation of heat generated at semiconductor switches from the cushions toward the heat pipe's heat receive portions. In brief, this embodiment offers further enhanced heat releasability by a degree corresponding to the absence of any thermal resistivities of wiring plates and insulators in the heat transfer path thereof. Also importantly, the heat pipes' heat receive portions are present at both the drain electrode surface and the source electrode surface of a semiconductor switch with buffer or "cushion" members interposed therebetween, which may lead to improvement in resultant heat releasability.

It should be noted that the conductive blocks 28a-28c with the heat pipe's heat receive portions built therein are different in voltage potential from one another; thus, as shown in Fig. 16, letting part of the heat pipe 31a, 31b, 31c be formed of dielectric pipe 32a, 32b, 32c results in accomplishment of an electrical insulated structure.

As discussed above, the first embodiment of the present invention is structured so that the DC wiring plate (e.g. positive DC wiring plate 3) is used as one pressurization plate for reducing the inductance of main circuit wiring lead pattern in combination of such wiring plate with cooling fins, not depicted. Alternatively the second embodiment is such that the output wiring lead (4, 5, 6) is used as one-side pressurization plate with addition of a wiring plate (25) thereto, thus reducing the inductance of the main circuit wiring lead pattern. The third embodiment is structured so that the drain electrode surfaces of all the semiconductor switches (12a-12f) for use as heat release area-increased electrode surfaces are specifically mounted to face the cooler side to thereby improve the resulting thermal resistivity. The fourth embodiment is structured so that certain part corresponding to a single phase is taken out of it to thereby improve production yields in the manufacture of the device. The fifth embodiment is structured so that each semiconductor switch is interposed or "sandwiched" between the heat receive portions of heat pipes, thus improving the heat releasability thereof.

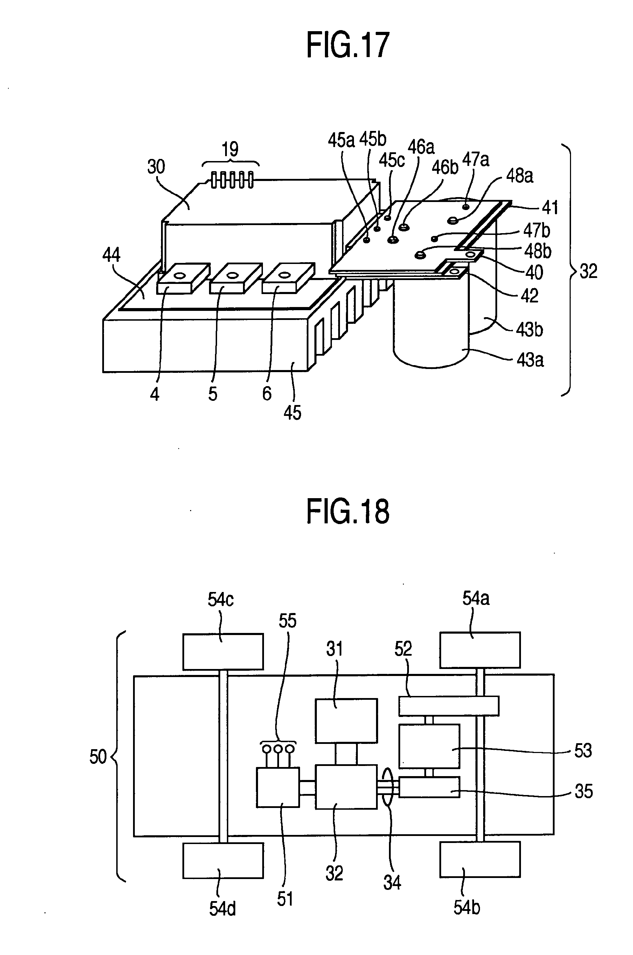

An explanation will next be given of an electric power conversion apparatus employing the semiconductor device of the instant invention with reference to Fig. 17. Fig. 17 is a diagram showing a top perspective view of the power converter in accordance with the second embodiment of this invention. In Fig. 17, numerals 4 to 6 designate output terminals; 30 denotes a semiconductor device; 40 is a positive polarity wiring plate; 41, insulative or dielectric plate; 42, negative wiring plate; 43a-43b, capacitors; 44, dielectric sheet; 45, cooling fins; 45a-45c, bolts; 46a-b, bolts; 47a-b, bolts; 48a-b, bolts; 19, signal pins. The positive wiring plate 40 and negative wiring plate 42 are provided with screw holes for connection of a power cable. The positive wiring plate 40 and dielectric plate 41 plus negative wiring plate 42 are arranged to have a multilayer structure. The positive wiring plate 40 and the semiconductor device's positive wiring plate are electrically connected together by use of bolts 45a-45c whereas the negative wiring plate 42 and the semiconductor device's negative wiring plate are electrically coupled together by bolts 46a-46b. The capacitors 43a-43b have respective positive and negative terminals, which are connected to the positive wiring plate 40 and negative wiring plate 42 by screws 47a-47b and 48a-48b. The semiconductor device 30 is area-secured to the assembly of cooling fins 45 with the dielectric sheet 44 sandwiched therebetween. As shown in Fig. 17 the semiconductor device incorporating the principles of the invention is mountable with a similar structure to that of prior art semiconductor devices. Accordingly, using the semiconductor device of the invention makes it possible to provide a power converter which is readily replaceable with prior art semiconductor devices while improving the reliability thereof.

An example will next be set forth with reference to Fig. 18, which is arranged to apply the power converter using the illustrative semiconductor device to a land vehicle drive system.

Fig. 18 is a diagram showing a motor vehicle drive system. In this drawing, numeral 35 designates an electric motor; 32 denotes an electric power converter; 31 is a DC power supply; 34, output wiring leads; 50, land vehicle such as an automobile; 51, control device; 52, transport module such as transmission/gearing device; 53, engine; 54a-54d, wheels; 55, signal terminals. The signal terminals are designed to receive several signals relating to automobile driving states and also a driver's instructions as to go-ahead, acceleration, deceleration, stop and others. The control device 51 is operatively responsive to receipt of information as received at the signal terminal(s) for sending forth one or more control signals toward the power converter, thereby driving the motor 35. The motor 35 transfers a torque to an engine shaft, thus enabling the wheels to be driven via the transmission device 52. In brief, with this drive system, it is possible even when the automobile engine 53 is being stopped to permit the motor 35 to drive the wheels 54a-b; in addition, it is possible to torque-assist them even during activation of the engine 53. Furthermore, it is also possible to charge up the DC power supply 31 by a process including the steps of letting the engine 53 drive the motor 35 and then letting power converter 32 convert the AC produced by motor 35 into DC.

In this drive system, it should be required that large current be used to drive the motor 35 in view of the fact that an increased torque is called for the motor during wheel driving by use of the motor alone and/or during torque-assisting. Due to this, it is inevitable to employ a power converter with large current controllability. Consequently, according to the power converter using the semiconductor device embodying the invention, it is possible to provide a land vehicle incorporating therein a drive system satisfying such larger torque requirement. Optionally the motor 35 may be replaced by induction motors or alternatively by certain motors capable of producing the requisite driving force based on AC currents, such as synchronous motors or equivalents thereof.

It has been stated that the first embodiment of the present invention is structured so that the DC wiring plate (e.g. positive DC wiring plate 3) is used as one pressurization plate for reducing the inductance of main circuit wiring lead pattern in combination of such wiring plate with cooling fins, not depicted. Alternatively the second embodiment is such that the output wiring lead (4, 5, 6) is used as one-side pressurization plate with addition of a wiring plate (25) thereto, thus reducing the inductance of the main circuit wiring lead pattern. The third embodiment is structured so that the drain electrode surfaces of all the semiconductor switches (12a-12f) for use as heat release area-increased electrode surfaces are specifically mounted to face the cooler side to thereby improve the resulting thermal resistivity. The fourth embodiment is structured so that certain part corresponding to a single phase is taken out of it to thereby improve production yields in the manufacture of the device. The fifth embodiment is structured so that each semiconductor switch is interposed or "sandwiched" between the heat receive portions of heat pipes, thus improving the heat releasability thereof. Thus it is possible to provide the semiconductor device with improved reliability relative to temperature cycles. It is also possible to establish an improved hightorque motor drive system capable of increasing the output capacity of such semiconductor device.

## Claims

1. A semiconductor device (30) comprising a positive polarity wiring plate (3, 3a-3c), a negative polarity wiring plate (2, 2a-2c), an output wiring plate (4-6, 4'-6'), a semiconductor switch element (12a-12f), and a conductive buffer material (11a-11f, 13a-13f), said semiconductor switch element and said buffer material being compressively interposed between said output wiring plate and positive polarity wiring plate and also between said output wiring plate and negative polarity wiring plate for constitution of bridge circuitry, wherein
any one of said positive polarity wiring plate, said negative polarity wiring plate and said output wiring plate is adapted for use as one support body of a pressurization structure.

2. A semiconductor device (30) comprising a positive polarity wiring plate (3, 3a-3c), a negative polarity wiring plate (2, 2a-2c), output wiring plates (4-6, 4'-6'), more than one semiconductor switch element (12a-12f) and a casing (1) containing these components therein with said semiconductor switch element being interposed between said output wiring plate and positive polarity wiring plate and also between said output wiring plate and negative polarity wiring plate to thereby make up bridge circuitry, . wherein
said positive polarity wiring plate and negative polarity wiring plate are disposed at a surface opposing a cooling fin assembly (27) of said casing while letting said output wiring plates be disposed at a position opposing said positive polarity wiring plate and a position opposing said negative polarity wiring plate respectively to thereby utilize said positive polarity wiring plate and negative polarity wiring plate as one-side pressurization plates.

3. A semiconductor device (30) comprising a positive polarity wiring plate (3, 3a-3c), a negative polarity wiring plate (2, 2a-2c), output wiring plates (4-6, 4'-6'), more than one semiconductor switch element (12a-12f) and a casing (1) containing these components therein with said semiconductor switch element being interposed between said output wiring plate and positive polarity wiring plate and also between said output wiring plate and negative polarity wiring plate to thereby make up bridge circuitry, wherein
said output wiring plates are disposed at a surface opposing a cooling fin assembly (27) of said casing while letting said positive polarity wiring plate and said negative polarity wiring plate be disposed at surfaces opposing said output wiring plates respectively and further letting a conductive plate (25) be disposed opposing said positive polarity wiring plate and said negative polarity wiring plate for permitting utilization of said output wiring plates as one-side pressurization plates.

4. A semiconductor device (30) comprising a positive polarity wiring plate (3, 3a-3c), a negative polarity wiring plate (2, 2a-2c), output wiring plates (4-6, 4'-6'), more than one semiconductor switch element (12a-12f) and a casing (1) containing these components therein with said semiconductor switch element being interposed between said output wiring plate and positive polarity wiring plate and also between said output wiring plate and negative polarity wiring plate to thereby make up bridge circuitry, wherein
said output wiring plates and one of the positive and negative polarity wiring plates are disposed at a surface opposing cooling fins (27) of said casing while disposing said one of the positive and negative polarity wiring plates at surface opposing said output wiring plates with an output wiring plate to be connected to said output wiring plates being disposed at a surface opposing said one of the positive and negative wiring plates to thereby utilize as one-side pressurization plates said output wiring plates and said one of the positive and negative wiring plates as disposed at the surface opposing the cooling fins.

5. The semiconductor device as set forth in claim 1 wherein said bridge circuitry includes a half bridge circuit.

6. The semiconductor device as set forth in claim 2 wherein said bridge circuitry includes a half bridge circuit.

7. The semiconductor device as set forth in claim 3 wherein said bridge circuitry includes a half bridge circuit.

8. The semiconductor device as set forth in claim 4 wherein said bridge circuitry includes a half bridge circuit.

9. A semiconductor device (30) comprising a positive polarity wiring plate (3a-3c), a negative polarity wiring plate (2a-2c), an output wiring plate (4-6) disposed between said positive polarity wiring plate and said negative polarity wiring plate, and semiconductor switch elements (12a-12f) as disposed between said positive polarity wiring plate and said output wiring plate and between said negative polarity wiring plate and output wiring plate respectively, said positive polarity wiring plate and said negative polarity wiring plate interposing said semiconductor switch elements therebetween for constitution of bridge circuitry, wherein
a conductive block (28a-28i) with a heat receiving portion of a heat pipe is disposed between said semiconductor switch elements and the wiring plate.

10. An electric power conversion apparatus (32) for mutual conversion of a direct current ("DC") voltage and a potentially variable alternate current (AC) voltage with variable frequency, said apparatus comprising the semiconductor device (30) as set forth in claim 1, and a capacitor (32a, 43b) as connected between said positive polarity wiring plate (40) and said negative polarity wiring plate (42) of said semiconductor device.

11. An electric power conversion apparatus (32) for mutual conversion of a DC voltage and a potentially variable AC voltage with variable frequency, said apparatus comprising the semiconductor device (30) as set forth in claim 2, and a capacitor (43a, 43b) as connected between said positive polarity wiring plate (40) and said negative polarity wiring plate (42) of said semiconductor device.

12. An electric power conversion apparatus (32) for mutual conversion of a DC voltage and a potentially variable AC voltage with variable frequency, said apparatus comprising the semiconductor device (30) as set forth in claim 3, and a capacitor (43a, 43b) as connected between said positive polarity wiring plate (40) and said negative polarity wiring plate (42) of said semiconductor device.

13. An electric power conversion apparatus (32) for mutual conversion of a DC voltage and a potentially variable AC voltage with variable frequency, said apparatus comprising the semiconductor device (30) as set forth in claim 4, and a capacitor (43a, 43b) as connected between said positive polarity wiring plate (40) and said negative polarity wiring plate (42) of said semiconductor device.

14. An electric power conversion apparatus (32) for mutual conversion of a DC voltage and a potentially variable AC voltage with variable frequency, said apparatus comprising the semiconductor device (30) as set forth in claim 9, and a capacitor (43a, 43b) as connected between said positive polarity wiring plate (40) and said negative polarity wiring plate (42) of said semiconductor device.

15. An electric power conversion apparatus (32) for use in a land vehicle (50) for driving a main electric motor (35) for land vehicle drive, said apparatus comprising the semiconductor device (30) set forth in claim 1.

16. An electric power conversion apparatus (32) for use in a land vehicle (50) for driving a main electric motor (35) for land vehicle drive, said apparatus comprising the semiconductor device (30) set forth in claim 2.

17. An electric power conversion apparatus (32) for use in a land vehicle (50) for driving a main electric motor (35) for land vehicle drive, said apparatus comprising the semiconductor device (30) set forth in claim 3.

18. An electric power conversion apparatus (32) for use in a land vehicle (50) for driving a main electric motor (35) for land vehicle drive, said apparatus comprising the semiconductor device (30) set forth in claim 4.

19. An electric power conversion apparatus (32) for use in a land vehicle (50) for driving a main electric motor (35) for land vehicle drive, said apparatus comprising the semiconductor device (30) set forth in claim 9.

20. An automotive vehicle (50) comprising the semiconductor device (30) set forth in claim 1, a vehicle-driving electric motor (35) as driven by said semiconductor device.

21. An automotive vehicle (50) comprising the semiconductor device (30) set forth in claim 2, a vehicle-driving electric motor (35) as driven by said semiconductor device.

22. An automotive vehicle (50) comprising the semiconductor device (30) set forth in claim 3, a vehicle-driving electric motor (35) as driven by said semiconductor device.

23. An automotive vehicle (50) comprising the semiconductor device (30) set forth in claim 4, a vehicle-driving electric motor (35) as driven by said semiconductor device.

24. An automotive vehicle (50) comprising the semiconductor device (30) set forth in claim 9, a vehicle-driving electric motor (35) as driven by said semiconductor device.
